# EUROPEAN PATENT APPLICATION

(11) **EP 2 613 376 A1**
(43) Date of publication of application: **10.07.2013**
(21) Application number: 10856706.6
(22) Date of filing: 02.09.2010
(51) Int. Cl.: H01L 51/50, H05B 33/10

(54) **ELECTROLUMINESCENT ELEMENT, ELECTROLUMINESCENT ELEMENT MANUFACTURING METHOD, DISPLAY DEVICE, AND ILLUMINATION DEVICE**

(71) Applicant: Showa Denko K.K., Tokyo 105-8518 (JP)
(72) Inventor: KONDO, Kunio, Chiba-shi Chiba 267-0056 (JP); SAKO, Kanjiro, Chiba-shi Chiba 267-0056 (JP); TAJIMA, Masaru, Chiba-shi Chiba 267-0056 (JP); HIROSE, Katsumasa, Chiba-shi Chiba 267-0056 (JP)
(74) Representative: Strehl, Peter
(86) International application number: PCT/JP2010/065030
(87) International publication number: WO 2012/029156

(57) **Abstract**

An electroluminescent element (10) is provided with: an anode layer (12), a cathode layer (14) arranged to face the anode layer (12), pillars (13) formed in the space between the anode layer (12) and the cathode layer (14), and a light emitting layer (17) formed at a location other than the locations where the pillars (13) are formed; and the pillars (13) are formed so that the following conditions (1) and (2) are at least 95% satisfied. With this configuration, an electroluminescent element is provided that is unlikely to suffer from emission unevenness or short circuit and has high durability. (1) At least a part of the pillars (13) is included within a 10-µm diameter circular region the center of which is an arbitrary position on the surface of the anode layer (12). (2) At least a part of the light emitting layer (17) is included within a 20-µm diameter circular region the center of which is an arbitrary position on the surface of the anode layer (12).

## Description

### Technical Field

The present invention relates to an electroluminescent element or the like used for, for example, a display device or an illumination device.

### Background Art

In recent years, devices utilizing the electroluminescence phenomenon have increased in importance. As such a device, an EL (electroluminescent) element in which light emitting materials are formed to be a light emitting layer, and a pair of electrodes including an anode and a cathode is attached to the light emitting layer, and light is emitted by applying a voltage thereto, becomes a focus of attention. In this kind of electroluminescent element, holes and electrons are injected from the anode and the cathode, respectively, by applying a voltage between the anode and the cathode, and an energy generated by coupling the injected electrons and holes in the light emitting layer is used to perform light emission. In other words, the electroluminescent element is a device utilizing a phenomenon in which the light emitting material of the light emitting layer is excited by the energy produced by the coupling, and light is emitted when an excited state returns to a ground state again.

In the case where the electroluminescent element is used as a display device, since the light emitting material is capable of self-emitting, the device has characteristics that a response speed as the display device is fast and a view angle is wide. Further, due to its structural feature of the electroluminescent element, there is an advantage that the thickness of the display device may be reduced with ease. Moreover, in the case of an organic electroluminescent element using, for example, an organic substance as the light emitting material, characteristics are obtained such that light with high color purity is readily obtained depending upon selection of the organic substance, and thereby a wide color gamut is available.
Further, since the electroluminescent element is capable of emitting white light, and is an area light source, usage of the electroluminescent element to be incorporated into an illuminating device is suggested.

In Patent Document 1, it is disclosed that, in an organic electroluminescence element including an anode, an organic layer that includes an organic light emitting layer and is composed of at least one layer and a cathode, a surface of the anode that contacts at least the organic layer is formed to have the maximum height roughness (Rmax) defined by definition of the surface roughness by JIS (Japanese Industrial Standard) and description (JIS B 0601-2001) is 50 angstrom.
In Patent Document 2, there is disclosed an organic electroluminescent element including at least one anode, a hole transporting layer, a light emitting layer and the like composed of organic compound layers, and a cathode, which are laminated on a transparent glass support body in order, and also including a configuration in which the maximum height roughness Rmax of the anode is 50 nm or less, or the value of the mean roughness Ra of the anode is less than 5 nm, and/or the contact angle of the surface of the anode with respect to water is less than 20 degree.

### Citation List

### Patent Literature

Patent Document 1: Japanese Patent Application Laid-Open Publication No. 9-245965
Patent Document 2: Japanese Patent Application Laid-Open Publication No. 9-7770

### Disclosure of Invention

### Technical Problem

Here, in general, if an electrode layer of an electroluminescent element has asperities, a contact area between the electrode layer and a light emitting layer is increased in microscopic view. Therefore, light emitting efficiency is apt to be improved. However, there were some cases in which points where current concentration or short circuit occurred were caused, and accordingly durability of the electroluminescent element was deteriorated. In a method of using a substrate having high surface smoothness for suppressing this problem, ordinarily, a polishing process for polishing a surface of the electrode layer or a surface of a glass substrate is separately required. Since abrasives used in polishing are tend to remain on the surface of the electrode layer, a precision cleaning process under severe conditions using a high-alkali cleaner or the like is further required. Consequently, by addition of these processes, there were some cases where production costs of the electroluminescent elements were increased and the electrode layer was deteriorated due to the precision cleaning process.

### Solution to Problem

An electroluminescent element according to the present invention includes: a first electrode layer; a second electrode layer arranged to face the first electrode layer; pillars formed in a space between the first electrode layer and the second electrode layer; and a light emitting layer formed in a location other than locations where the pillars are formed, wherein the pillars are formed to satisfy (1) and (2) below at a rate of 95% or more: (1) at least a part of the pillars is included in a circular region with a diameter of 10 µm around an arbitrary position on a surface of the first electrode layer; and (2) at least a part of the light emitting layer is included in a circular region with a diameter of 20 µm around an arbitrary position on a surface of the first electrode layer.

Here, it is preferable that a surface roughness (Rmax) of a surface of the first electrode layer, on which the pillars are to be formed, is 10 nm or more assuming that a reference length L is 50 µm.
Moreover, it is preferable that height of the pillar is 50 nm to 300 nm, and it is more preferable that the pillar substantially has a cylindrical shape.
The light emitting layer preferably includes an organic material that emits phosphorescent light.

Further, an electroluminescent element manufacturing method includes: forming a first electrode layer on a support body; forming pillars on the first electrode layer; forming a light emitting layer by a coating method in a location other than locations where the pillars are formed; and forming a second electrode layer on the pillars and the light emitting layer, wherein the pillars are formed to satisfy (1) and (2) below at a rate of 95% or more: (1) at least a part of the pillars is included in a circular region with a diameter of 10 µm around an arbitrary position on a surface of the first electrode layer; and (2) at least a part of the light emitting layer is included in a circular region with a diameter of 20 µm around an arbitrary position on a surface of the first electrode layer.

Here, the coating method is preferably any one of a spin coating method, an ink-jet method, a printing method and a slit coating method.

Moreover, a display device according to the present invention includes the electroluminescent element described above.

Moreover, an illumination device according to the present invention includes the electroluminescent element described above.

### Advantageous Effects of Invention

According to the present invention, it is possible to provide an electroluminescent element or the like, in which non-uniformity in light emission or short circuit hardly occurs, that is easily manufactured and has high durability.

### Brief Description of Drawings

FIG. 1A is a partial cross-sectional view illustrating a specific example of an electroluminescent element to which the exemplary embodiment is applied;
FIG. 1B is a diagram enlarging a part of FIG. 1A;
FIGS. 2A and 2B are diagrams in which the electroluminescent element is viewed from the direction II in FIG. 1A to illustrate various modes in distribution of pillars;
FIGS. 3A to 3F are a diagrams for illustrating a manufacturing method of the electroluminescent element to which the exemplary embodiment is applied;
FIG. 4 is a diagram for illustrating a specific example of a display device using the electroluminescent element in the exemplary embodiment;
FIG. 5 is a diagram for illustrating a specific example of an illumination device including the electroluminescent element in the exemplary embodiment;
FIG. 6 is a diagram showing a relation between a surface roughness (Rmax) and short circuit or the like;
FIG. 7A is a partial cross-sectional view illustrating an electroluminescent element without providing the pillars; and
FIG. 7B is a diagram enlarging a part of FIG. 7A.

### Description of Embodiments

### (Electroluminescent Element)

Hereinafter, an exemplary embodiment of the present invention will be described in detail with reference to the attached drawings.

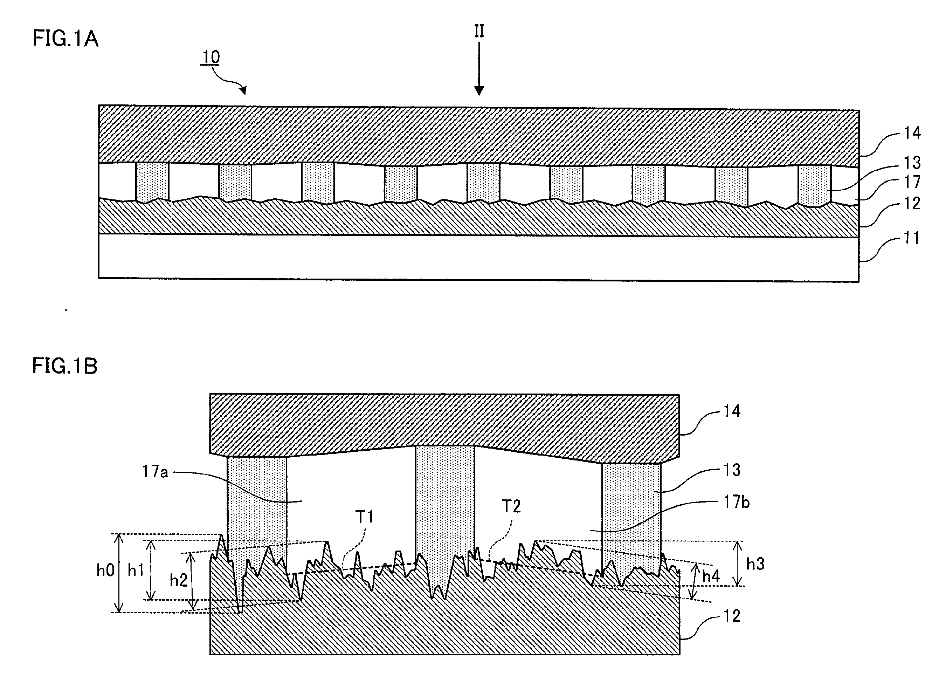

FIG. 1A is a partial cross-sectional view illustrating a specific example of an electroluminescent element to which the exemplary embodiment is applied. FIG. 1B is a diagram enlarging a part of FIG. 1A.
A electroluminescent element 10 shown in FIG. 1A employs a configuration in which a support body 11, an anode layer 12 formed on the support body 11, in the case where the support body 11 side is assumed to be a lower side, as a first electrode layer for hole injection, a cathode layer 14 arranged to face the anode layer 12 as a second electrode layer for electron injection, and a light emitting layer 17 that is formed in a space between the anode layer 12 and the cathode layer 14 and includes a light emitting material that emits light upon application of a voltage are laminated in order. In the light emitting layer 17, pillars 13 having insulating properties to be arranged in predetermined distribution are formed in a shape of penetrating the light emitting layer 17. In other words, the light emitting layer 17 is formed in a portion other than the portions between the anode layer 12 and the cathode layer 14 where the pillars 13 are formed.

The support body 11 serves as a substrate for forming the anode layer 12, the pillars 13, the cathode layer 14 and the light emitting layer 17. For the support body 11, a material that satisfies mechanical strength required for the electroluminescent element 10 is used.

The material for the support body 11, in the case where the light is to be taken out from the support body 11 side of the electroluminescent element 10, is required to be transparent to the wavelength of light to be emitted. Specific examples include: glasses such as sapphire glass, lime-soda glass and quartz glass; transparent resins such as acrylic resins, methacrylic resins, polycarbonate resins, polyester resins and nylon resins; silicon resins; and transparent metal oxide such as aluminum nitride and alumina. In a case of using, as the support body 11, a resin film or the like made of the aforementioned transparent resins, it is preferable that permeability to gas such as moisture and oxygen is low. In a case of using a resin film or the like having high permeability to gas, a thin film having a barrier property for inhibiting permeation of gas is preferably formed as long as the light transmission is not lost.

In the case where it is unnecessary to take out the light from the support body 11 side of the electroluminescent element 10, the material of the support body 11 is not limited to the ones which are transparent, and the ones may be opaque. The specific examples of the material of the support body 11 include: in addition to the above-described materials, materials selected from [i] simple substances such as silicon (Si), copper (Cu), silver (Ag), gold (Au), platinum (Pt), tungsten (W), titanium (Ti), tantalum (Ta) and niobium (Nb); alloys thereof; [ii] stainless steel; [iii] oxides such as SiO₂, Al₂O₃ and the like; and [iv] a semiconductor material such as n-Si and the like.
Although the thickness of the support body 11 depends on the required mechanical strength, it is preferably 0.1 mm to 10 mm, and more preferably 0.25 mm to 2 mm.

Voltage is applied between the anode layer 12 and the cathode layer 14, and holes are injected from the anode layer 12 to the light emitting layer 17. A material used for the anode layer 12 is necessary to have electric conductivity. Specifically, it has a low work function, and the work function is preferably not more than -4.5 eV. In addition, it is preferable that the electric resistance is not notably changed for an alkaline aqueous solution.

As the material satisfying such requirements, metals, alloys or metal oxides can be used. As the metal oxides, indium tin oxide (ITO) and indium zinc oxide (IZO) are provided, for example. As the metals, provided are: copper (Cu); silver (Ag); gold (Au); platinum (Pt); tungsten (W); titanium (Ti); tantalum (Ta); niobium (Nb) and the like. Further, alloys such as stainless steel including these metals can be used. The thickness of the anode layer 12 is formed to be, for example, 2 nm to 2 µm. It should be noted that, the work function can be measured by, for example, an ultraviolet photoelectron spectroscopy.

Moreover, on a surface of the anode layer 12 on the cathode layer 14 side (hereinafter, simply referred to as "the surface of the anode layer 12", except where specifically noted), in a case where a range of some degree is microscopically viewed, there are asperities, and further, there exist protrusions, which are most protruding portions within the range. Though described later, in the exemplary embodiment, the asperities were shown with exaggeration in FIG. 1B for convenience of illustration.

The pillars 13 are provided between the anode layer 12 and the cathode layer 14 and arranged in predetermined distribution. Accordingly, at the locations where the pillars 13 are formed, the anode layer 12 and the cathode layer 14 are maintained with predetermined spacing.

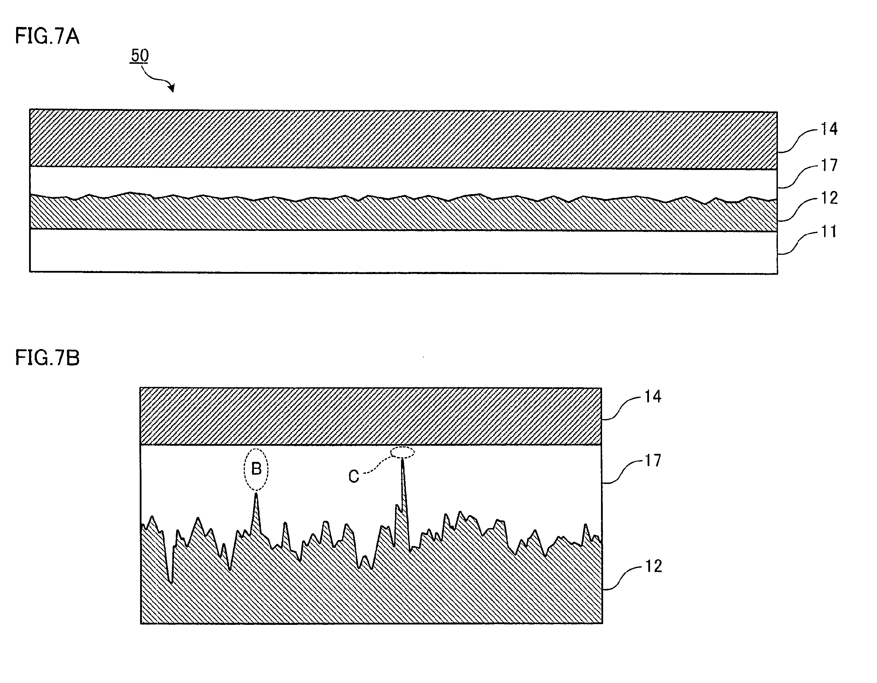

FIG. 7A is a partial cross-sectional view illustrating an electroluminescent element without providing the pillars 13. FIG. 7B is a diagram enlarging a part of FIG. 7A.
An electroluminescent element 50 shown in FIGS. 7A and 7B is different from the electroluminescent element 10 shown in FIGS. 1A and 1B in the point that the electroluminescent element 50 is not provided with the pillars 13. In other words, the electroluminescent element 50 includes a support body 11 and three layers formed on the support body 11, namely, an anode layer 12, a light emitting layer 17 and a cathode layer 14. It should be noted that, in the exemplary embodiment, the asperities on the anode layer 12 are shown with exaggeration in FIG. 7B for convenience of illustration.

When a voltage is applied between the anode layer 12 and the cathode layer 14 of the electroluminescent element 50, holes are injected from the anode layer 12 and electrons are injected from the cathode layer 14. Then the electroluminescent element 50 emits light by recoupling the holes and the electrons in the light emitting layer 17. Here, protrusions on the anode layer 12 can be represented by, for example, a surface roughness (Rmax) when a reference length L is assumed to be 50 µm, and represented as 10 nm or more and 200 nm or less. If the protrusions of this degree of size exist on the surface of the anode layer 12, the current is more likely to flow to the cathode layer 14 in these portions. In other words, since the distance between the anode layer 12 and the cathode layer 14 becomes shorter at the locations of the protrusions, resistance by the light emitting layer 17 is reduced. Accordingly, larger current flows in these locations. In FIG. 7B, such a location is exemplified as a region B. At the location, the light emitting material constituting the light emitting layer 17 tends to be more deteriorated than other regions. Therefore, the electroluminescent element 50 tends to have a short lifespan. In other words, the electroluminescent element 50 tends to have low durability. Further, when the protrusions become larger and the distance between the anode layer 12 and the cathode layer 14 is still more reduced, short circuit occurs in some cases. In FIG. 7B, such a location is exemplified as a region C. If the short circuit occurs, light is not emitted at the location. Moreover, current leakage occurs due to the short circuit. As a result, current not to be used to emit light flows through the electroluminescent element 50, to thereby cause deterioration in light emitting efficiency. It should be noted that, hereinafter, the case where the current becomes large and the case where the short circuit occurs are collectively referred to as "short circuit or the like" in some cases.
If the electroluminescent element 10 in the exemplary embodiment is applied, the short circuit or the like is not outstanding when Rmax is 200 nm or less. It should be noted that Rmax can be calculated by measuring the surface of the anode layer 12 by an AFM or a stylus smoothness sensor. After the pillars 13 are formed, since the support body 11 is broken and a cross section thereof is observed by an SEM to enable to obtain a shape of the surface of the anode layer 12, it is possible to calculate Rmax based thereon.

To solve such a problem in which short circuit or the like occurs, in the exemplary embodiment, the pillars 13 are provided to be arranged in predetermined distribution. Hereinafter, returning to FIGS. 1A and 1B, description will be given of the difference in distance between the anode layer 12 and the cathode layer 14 in the case of not providing the pillars 13 and in the case of providing the pillars 13.

In FIG. 1B, in the case where the pillars 13 are not provided, the surface roughness (Rmax) as a maximum distance between the protrusion and depressing portion in the asperities on the anode layer 12 is h0 in the cross-sectional region shown in FIG. 1B. In contrast, in the case where the pillars 13 are provided, the surface roughness (Rmax) of the anode layer 12 in the cross-sectional region where a light emitting layer 17a is formed is h1. Further, the surface roughness (Rmax) of the anode layer 12 in the cross-sectional region where a light emitting layer 17b is h3. In the case of the exemplary embodiment, h1 and h3 are smaller than h0 (h1 < h0, h3 < h0). In other words, by providing the pillars 13, the surface roughness (Rmax) of the anode layer 12 in the light emitting layer 17 (17a, 17b) tends to be small. The short circuit or the like as described above is more likely to occur in the case where the distance between the anode layer 12 and the cathode layer 14 is reduced. Accordingly, provision of the pillars 13 as in the exemplary embodiment causes the short circuit or the like to hardly occur. Consequently, light emitting efficiency of the electroluminescent element 10 is apt to be improved, and durability is apt to be increased. Moreover, in the case of the exemplary embodiment, it is also possible to use the anode layer 12 without polishing, and therefore, the problem of residual abrasives on the surface of the anode layer 12 rarely occurs.

If, for obtaining the anode layer 12 with small protruding portions, for example, it is required to polish the surface of the support layer 11, which is a base thereof, and/or the surface of the anode layer 12, as disclosed in Patent Document 1. However, in reality, it is difficult to uniformly perform adjustment of the surface roughness (Rmax) merely by polishing an entire surface of the anode layer 12. On the other hand, in the exemplary embodiment, adjustment of the surface roughness (Rmax) can be carried out by performing adjustment of distribution of the pillars 13. Though details will be described later, adjustment of distribution of the pillars 13 can be easily performed by adjusting a mask pattern in executing lithography or the like. Consequently, in the exemplary embodiment, it is easy to reduce the locations where the short circuit or the like occurs without making it absolutely a requirement to have a process for reducing the protruding portions of the anode layer 12.

Microscopically observed Rmax of the surface of the anode layer 12 can be sufficiently reduced by adjusting the distribution of the pillars 13. To do this,
(1) the pillars 13 are formed such that at least a part of the pillars 13 is included within a circular region with a diameter of 10 µm, which is around an arbitrary position on the surface of the anode layer 12.
   In addition, the diameter of the circular region is more preferably 3 µm, and still more preferably 1 µm.
   Moreover, since the pillars 13 are not necessarily involved in light emission, if an area of the pillars 13 occupying on the surface of the anode layer 12 ("pillar area") is large, the ratio of an area occupied by the light emitting layer 17 ("light emitting layer area") becomes small. On the other hand, if the area is too small, sufficient mechanical strength for the pillars 13 is not available, and accordingly, an extraordinary element preparation process is to be required. Specifically, the area of the pillars 13 to the whole (namely, the total of the area of the light emitting layer 17 and the area of the pillars 13) is preferably 3% to 80%, more preferably 6% to 70%, and most preferably 10% to 60%.

Further, if portions where the area of the pillars 13 is large are unevenly distributed, since light emission intensity in these portions becomes weaker than other portions, these portions tend to be a cause of unevenness in electroluminescent light emission. Accordingly, the pillars 13 are
(2) formed such that at least a part of the light emitting layer 17 is included within a circular region with a diameter of 20 µm, which is around an arbitrary position on the surface of the anode layer 12.
   In addition, the diameter of the circular region is more preferably 6 µm, and still more preferably 2 µm.

It is ideal that the plural pillars 13 are arranged on all over the light emitting surface to satisfy the above conditions; however, even in a case where the plural pillars 13 include some chipped, broken or enlarged pillars 13, as long as ratio of these to the entire light emitting surface is small, the plural pillars 13 can be used with no problem. Specifically, the pillars 13 are to be formed to satisfy the above-described (1) and (2) at a ratio of 95% or more. The ratio can be evaluated by, for example, pillar-shape normality to be described later.

It should be noted that the pillars 13 may be independent of one another, or part of configuration of each pillar 13 may overlap adjacent pillars 13.

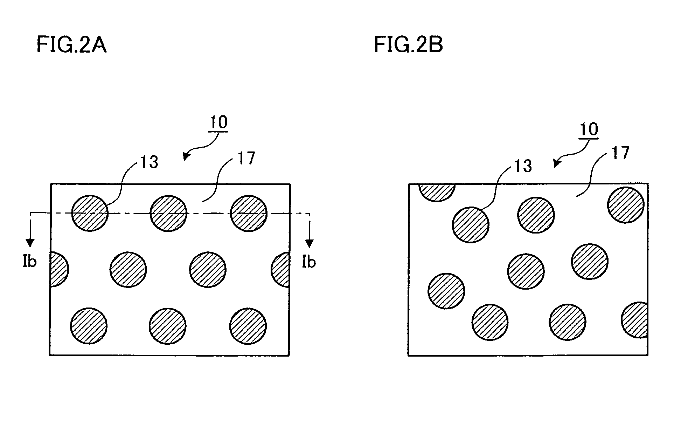

FIGS. 2A and 2B are diagrams in which the electroluminescent element 10 is viewed from the direction II in FIG. 1A to illustrate various modes in distribution of the pillars 13. It should be noted that, for convenience of illustration, a state where the cathode layer 14 is removed is shown in FIGS. 2A and 2B.

Here, the electroluminescent element 10 shown in FIG. 2A is in a case where each pillar 13 has a circular shape when viewed from the direction II in FIG. 1A. In other words, the pillar 13 has substantially a cylindrical shape. The pillars 13 are arranged with regularity, and are in a so-called staggered arrangement. It should be noted that FIG. 1B can be grasped as a Ib-Ib cross-sectional view in FIG. 2A.

The electroluminescent element 10 shown in FIG. 2B is similar to the electroluminescent element 10 shown in FIG. 2A in the point that the pillar 13 has a circular shape when viewed from the direction II in FIG. 1A, but is different in the point of having no regularity.
It should be noted that, in FIGS. 2A and 2B, description was given of the case where the pillar 13 has a circular shape when viewed from the direction II in FIG. 1A; however, the shape is not limited thereto, and there is no particular limitation. For example, when viewed from the direction II in FIG. 1A, the pillars 13 are able to have various shapes such as an elliptical shape, a quadrangular shape, a triangular shape and an indefinite shape.

In the light emitting layer 17, a surface on the cathode layer 14 side is preferably an inclined surface corresponding to the asperities of the anode layer 12. In the exemplary embodiment, as the inclined surface, a mode is adopted, in which the inclined surface is parallel to a line connecting a point where one pillar 13 contacts both of the anode layer 12 and the light emitting layer 17 and another point where the adjacent pillar 13 contacts both of the anode layer 12 and the light emitting layer 17. In FIG. 1B, this line is indicated by the dotted line T1 in the region of the light emitting layer 17a and the dotted line T2 in the region of the light emitting layer 17b.

In doing this way, the surface roughness (Rmax) of the anode layer 12 can further be reduced. In other words, in FIG. 1B, the surface roughness (Rmax) based on the dotted line T1 is h2. The surface roughness (Rmax) of the anode layer 12 based on the dotted line T2 becomes h4. Then, h2 has a value smaller than h1 (h2 < h1), and similarly, h4 has a value smaller than h3 (h4 < h3). Here, as described above, the top surfaces of the light emitting layers 17a and 17b are inclined corresponding to the dotted lines T1 and T2. In this case, the top surface of the light emitting layer 17a is in parallel with the dotted line T1, and the top surface of the light emitting layer 17b is in parallel with the dotted line T2. The undersurface of the cathode layer 14, which is formed on the light emitting layers 17a and 17b, also becomes an inclined surface that inclines similarly. As a result, the distance between the anode layer 12 and the cathode layer 14 becomes more uniformed when microscopically viewed, and thereby it is possible to cause the short circuit or the like to hardly occur.

The height of the pillar 13 is preferably less than 1 µm for suppressing an entire thickness of the electroluminescent element 10. Further, since the narrower the space between the anode layer 12 and the cathode layer 14, the lower the voltage required to emit light, it is preferable to make the pillar 13 thin as long as a sufficient dielectric strength for the voltage is available. Here, as an index for regarding to have the dielectric strength is preferably not more than 0.1 mA/cm² in current density passing between the anode layer 12 and the cathode layer 14, and more preferably not more than 0.01 mA/cm². The current density can be estimated by, for example, a current passing through an element having the pillar area of 100% prepared under the same conditions with the target electroluminescent element. Further, the electroluminescent element 10 preferably endures a voltage that is 2V higher than the driving voltage thereof. For example, in the case where the driving voltage thereof is 5V, it is required to satisfy the above-described current density when a voltage of about 7V is applied between the anode layer 12 and the cathode layer 14. The height of the pillar 13 that satisfies the requirement may preferably be 50 nm to 300 nm, and more preferably 50 nm to 200 nm.

Since the pillar 13 is formed between the anode layer 12 and the cathode layer 14, the material for forming the pillar 13 may have electrical resistance of the same level as the light emitting layer 17 or higher. In the case where the electrical resistance is lower than that of the light emitting layer 17, since main current passes through the pillars 13, the current flowing into the light emitting layer 17 to emit light is reduced for that amount. Accordingly, the pillar 13 is preferably made of a material having high resistance, and more preferably, made of an insulating material. The electrical resistance is preferably not less than 10⁸ Ω·cm, and more preferably not less than 10¹² Ω·cm. Specific examples of the material include: metal nitrides such as silicon nitride, boron nitride and aluminum nitride; metal oxides such as silicon oxide (silicon dioxide) and aluminum oxide; and metal fluorides such as sodium fluoride, lithium fluoride, magnesium fluoride, calcium fluoride and barium fluoride; and in addition, polymer compound such as polyimide, polyvinylidene fluoride and parylene; and coating silicone such as poly(phenylsilsesquioxane) can be used.

The cathode layer 14 injects the electrons into the light emitting layer 17 upon application of a voltage between the anode layer 12 and the cathode layer 14. The material used for the cathode layer 14 is not particularly limited as long as, similar to that of the anode layer 12, the material has electrical conductivity; however, the material that has a low work function and is chemically stable is preferred. In view of chemical stability, it is preferable to use materials having a work function of not more than -2.9 eV. The specific examples of the material include Al, MgAg alloy and alloys of Al and alkali metals such as AlLi and AlCa. The thickness of the cathode layer 14 is preferably in the range of 10 nm to 1 µm, and more preferably 50 nm to 500 nm. In the case of the electroluminescent element 10 of the exemplary embodiment, the light emitted from the light emitting layer 17 is to be taken out on the support body 11 side. Accordingly, the cathode layer 14 may be formed of an opaque material. It should be noted that, in a mode where the cathode layer 14 covers the light emitting layer 17 as a non-patterned film as in the exemplary embodiment, if the light is to be taken not only from the support body 11 side, but also from the cathode layer 14 side, it is necessary to form the cathode layer 14 by a transparent material such as ITO.

Moreover, to lower the barrier for the electron injection from the cathode layer 14 into the light emitting layer 17 and thereby to increase the electron injection efficiency, a cathode buffer layer that is not shown may be provided adjacent to the cathode layer 14. The cathode buffer layer is required to have a lower work function than the cathode layer 14, and metallic materials may be suitably used therefor. For example, the material thereof includes alkali metals (Na, K, Rb and Cs), alkaline earth metals (Sr, Ba, Ca and Mg), rare earth metals (Pr, Sm, Eu and Yb), one selected from fluoride, chloride and oxide of these metals and mixture of two or more selected therefrom. The thickness of the cathode buffer layer is preferably in the range of 0.05 nm to 50 nm, more preferably 0.1 nm to 20 nm, and still more preferably 0.5 nm to 10 nm.

Further, to lower the barrier for the electron injection from the cathode layer 14 into the light emitting layer 17 and thereby to increase the electron injection efficiency, an electron transporting layer (not shown) as an organic semiconductor layer including a material composed of an organic substance may be further provided between the cathode buffer layer and the light emitting layer 17.
Specific examples of the material used for the electron transporting layer include: quinoline derivatives; oxadiazole derivatives; perylene derivatives; pyridine derivatives; pyrimidine derivatives; quinoxaline derivatives; diphenylquinon derivatives; and nitrated fluorine derivatives.

It should be noted that the materials other than those described above may be used as an electron transporting layer, as long as the materials have an electron transport property higher than the hole transport property. In addition, the electron transporting layer may not only be a single layer, but also be a layer in which two or more layers composed of the materials described above are laminated. In the case where the film thickness of the electron transporting layer is too thin, an effect of enhancing the electron injection efficiency is not realized. On the other hand, in the case of being too thick, the voltage applied to the electron transporting layer increases and the driving voltage as an entire element increases, and thereby the power supply efficiency is lowered, which is not preferable. Therefore, the film thickness of the electron transporting layer satisfying these conditions is preferably in the range of 0.5 nm to 50 nm, and more preferably in the range of 1 nm to 10 nm, as a specific example.
As a method for forming the electron transporting layer, by a resistance heating method using a vacuum deposition device which is generally used, a deposition method in a vacuum state may be used.

The light emitting layer 17 includes a light emitting material that emits light by application of voltage and current supply. In the light emitting layer 17, holes injected from the anode layer 12 and the electrons injected from the cathode layer 14 are recombined, and light emission occurs.

As the material of the light emitting layer 17, either an organic material or an inorganic material may be used. In this case, the electroluminescent element 10 using an organic material is grasped as an organic electroluminescent element.
In a case where an organic material is used as the light emitting material, either low-molecular compound or high-molecular compound may be used. Specific examples may include light emitting low-molecular compound and light emitting high-molecular compound described in Oyo Butsuri (Applied Physics), Vol. 70, No. 12, pages 1419-1425 (2001) written by Yutaka Ohmori.

Since there are the pillars 13 in the exemplary embodiment, the light emitting layer 17 tends to be formed along vertex portions of the pillars 13. Accordingly, the surface of the light emitting layer 17 having been formed reflects the asperities of the anode layer 12. To suitably obtain the property that reflects the asperities in particular, it is preferable to form the light emitting layer 17 by a coating method, and the coating material preferably has wettability to the material that forms the pillars 13 and has an excellent coating property.
By using this kind of material, in the configuration of the electroluminescent element 10 in the exemplary embodiment, the light emitting layer 17 stably emits light among the pillars 13 due to the uniformly formed light emitting layer 17 among the pillars 13 with equal thickness, in other words, due to increase of a coverage property, to thereby increase uniformity in brightness of light to be outputted. Moreover, wettability of a coating surface is increased also by performing a UV-ozonization process or an oxygen-plasma process after forming the pillars 13, and as a result, it is possible to improve the coverage property.
In the coating method, materials having mainly a weight average molecular weight of 1000 to 2000000 are preferably used to improve a coating property. Moreover, to improve the coating property, it is possible to add additives for improving the coating property such as a leveling agent and a defoaming agent, or to add a binder resin having low charge trapping capability.
Moreover, a viscosity of a coating solution used in the coating method is preferably not more than 10 cps (centipoise), more preferably 8 cps, and still more preferably 5 cps. Since the coating solution having a viscosity within the range has high fluid flowability, the coating solution tends to selectively flows among the pillars 13 and to be formed as a film. In the case of a coating solution having a viscosity exceeding 10 cps, due to reduction of flowability, the light emitting material is apt to be formed as a film in some spaces other than the spaces among the pillars 13, to thereby require caution.

Specific examples of material having an excellent coating property include: arylamine having a predetermined structure with a molecular weight of 1500 or more to 6000 or less disclosed in Japanese Patent Application Laid Open Publication No. 2007-86639; and a predetermined high molecular phosphor disclosed in Japanese Patent Application Laid Open Publication No. 2000-34476.
Among the materials having excellent coating property, a light emitting high molecular compound is preferable in terms of simplification of manufacturing process of the electroluminescent element 10, and a phosphorescent light emitting compound is preferable in terms of high light emitting efficiency. Accordingly, a phosphorescent light emitting high molecular compound is particularly preferable. It should be noted that it is possible to mix plural materials or to add a low molecular light emitting material (for example, molecular weight of not more than 1000) within a scope which does not impair the coating property. On this occasion, an amount of adding the low molecular light emitting material is preferably not more than 30 wt%.
Further, the light emitting high molecular compound can be classified into a conjugate light emitting high molecular compound and a non-conjugate light emitting high molecular compound; however, among these, the non-conjugate light emitting high molecular compound is preferred.
From the aforementioned reasons, as the light emitting material used in the exemplary embodiment, a phosphorescent light emitting non-conjugate high molecular compound (a light emitting material which is a phosphorescent light emitting high molecular compound and also a non-conjugate light emitting high molecular compound) is especially preferable.

The light emitting layer 17 of the electroluminescent element 10 according to the present invention preferably includes at least the phosphorescent light emitting polymer (an organic material that emits phosphorescent light), on molecule of which contains a phosphorescent light emitting unit that emits phosphorescent light and a carrier transporting unit that transports a carrier. The phosphorescent light emitting polymer is obtained by copolymerizing a phosphorescent light emitting compound having a polymerizing substituent and a carrier transporting compound having a polymerizing substituent. The phosphorescent light emitting compound is a metal complex containing a metallic element selected from a group of iridium (Ir), platinum (Pt) and gold (Au), and especially, an iridium complex is preferable.

More specific examples and synthesis methods of the phosphorescent light emitting polymer are disclosed in, for example, Japanese Patent Application Laid-Open Publications Nos. 2003-342325, 2003-119179, 2003-113246, 2003-206320, 2003-147021, 2003-171391, 2004-346312, 2005-97589, and 2007-305734.

The light emitting layer 17 of the electroluminescent element 10 in the exemplary embodiment preferably includes the aforementioned phosphorescent light emitting compound, and may include a hole transporting compound or an electron transporting compound in order to supplement carrier-transporting property of the light emitting layer 17.

Even in a case of using a light emitting low-molecular compound instead of the aforementioned light emitting polymer compound as a light emitting material used for the light emitting layer 17, it is possible to form the light emitting layer 17. Further, it is also possible to add the aforementioned light emitting polymer compound as a light emitting material, as well as adding a hole transporting compound or an electron transporting compound.

In the electroluminescent element 10 in the exemplary embodiment, an inorganic material is usable for a light emitting body as mentioned above. The electroluminescent element using an inorganic material is served as an inorganic electroluminescent element. As an inorganic material, for example, an inorganic phosphor may be used. Specific examples of this inorganic phosphor, a configuration of the electroluminescent element and a manufacturing method thereof are disclosed in Japanese Patent Application Laid-Open Publication No. 2008-251531 as a known technique, for example.

### (Manufacturing Method of Electroluminescent Element)

Next, description will be given of a manufacturing method of the electroluminescent element to which the exemplary embodiment is applied, while the electroluminescent element 10 described with FIGSA. 1A and 1B is taken as an example.

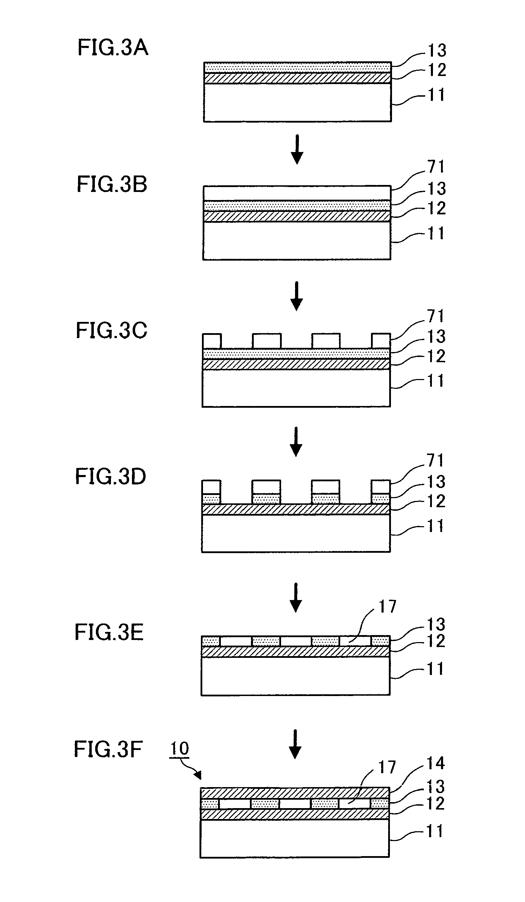

FIGS. 3A to 3F are diagrams for illustrating the manufacturing method of the electroluminescent element 10 to which the exemplary embodiment is applied.
First, on the support body 11, the anode layer 12 as a first electrode layer and the pillars 13 are laminated (FIG. 3A: lamination process). In the exemplary embodiment, a glass substrate was used as the support body 11. Further, ITO was used as a material for forming the anode layer 12, and silicon dioxide (SiO₂) was used as a material for forming the pillars 13.
For forming these layers on the support body 11, a resistance heating deposition method, an electron beam deposition method, a sputtering method, an ion plating method, a CVD method or the like may be used. Alternatively, if a film-forming method, that is, a method for applying a suitable material solved in a solvent to the support body 11 and then drying the same is applicable, these layers can be formed by a spin coating method, a dip coating method, an ink-jet printing method, a printing method, a spray-coating method and a dispenser-printing method or the like.
It should be noted that the process for forming the anode layer 12 can be omitted by using a so-called substrate with electrode in which ITO as the anode layer 12 has already been formed on the support body 11.

Further, instead of or in addition to executing the surface treatment of the anode layer 12, an effect similar to the surface treatment may be expected by forming an anode buffer layer (not shown). In the case where the anode buffer layer is formed by a wet process, the layer may be formed by a spin coating method, a casting method, a micro gravure coating method, a gravure coating method, a bar coating method, a roller coating method, a wire-bar coating method, a dip coating method, a spray coating method, a screen printing method, a flexo printing method, an offset printing method or an ink-jet printing method.

The compounds usable for the aforementioned layer formation by the wet process are not particularly limited as long as the compounds show good adhesion to the anode layer 12 and the light emitting compounds contained in the light emitting layer 17. Specific examples thereof include conductive polymers such as PEDOT as a mixture of poly-3,4-ethylenedioxythiophene and poly(styrenesulfonic acid) and PANI as a mixture of polyaniline and poly(styrenesulfonic acid). Organic solvents such as toluene and isopropyl alcohol may be added to the conductive polymers. Further, the conductive polymers may contain a third component such as surfactant. The surfactants used herein may contain a group selected from alkyl groups, alkylaryl groups, fluoroalkyl groups, alkylsiloxane groups, sulfates, sulfonates, carboxylates, amides, betaine structures and quaternary ammonium groups. Fluoride-based non-ionic surfactants may also be used.

Further, in a case where the anode buffer layer is formed by a dry process, the layer may be formed by a plasma treatment disclosed as an example in Japanese Patent Application Laid-Open Publication No. 2006-303412. In addition, the layer may be formed by a method for forming layers of metal, metal oxides or metal nitrides. Specific examples thereof include an electron-beam deposition method, a sputtering method, a chemical reaction method, a coating method and a vacuum deposition method.

Next, part of the pillars 13 formed in the process of FIG. 3A is removed. For doing this, a method using lithography may be used, for example. First, a resist solution is applied on the pillars 13 and then an excess resist solution is removed by spin coating or the like to form a resist layer 71 (FIG. 3B).

Thereafter, the resist layer 71 is covered with a mask (not shown), in which a predetermined pattern is rendered, exposed with ultraviolet light (UV), an electron beam (EB) or the like, and thereby exposure of the predetermined pattern is performed on the resist layer 71. Thereafter, light exposure portions of the resist layer 71 are removed by use of a developing solution, exposed pattern portions of the resist layer 71 are removed (FIG. 3C). By this process, the surfaces of the pillars 13 are exposed so as to correspond to the exposed pattern portions.

Then, by using the remaining resist layer 71 as a mask, exposed portions of the pillars 13 are removed by etching (FIG. 3D). Either dry etching or wet etching may be used as the etching method. Further, by combining isotropic etching and anisotropic etching at this time, the shape of the portions to be removed is controllable. Reactive ion etching (RIE) or inductive coupling plasma etching is used as the dry etching, and a method of immersion in diluted hydrochloric acid, diluted sulfuric acid, or the like is used as the wet etching. By the etching, the surface of the anode layer 12 is exposed so as to correspond to the aforementioned pattern. It should be noted that each process illustrated in FIGS. 3B to 3D can be considered as a gap forming process. Further, at this time, a distribution of the pillars 13 can be adjusted by adjusting the mask pattern.

Next, the remaining resist layer 71 is removed to form the light emitting layer 17 (FIG. 3E: light emitting layer forming process). For forming the light emitting layer 17, the above-mentioned coating method is used. Specifically, light emitting material solution in which the light emitting material for the light emitting layer 17 is dispersed in predetermined solvent such as organic solvent or water is firstly applied. To perform coating, various methods such as a spin coating method, a spray coating method, a dip coating method, an ink-jet method, a slit coating method, a dispenser method and a printing method may be used. After the coating is performed, the light emitting material solution is dried by heating or vacuuming, and thereby the light emitting layer 17 is formed. At this time, the light emitting layer 17 is formed so as to fill in the gap portions among the pillars 13 by setting coating conditions. Moreover, in addition, since it is possible to form the light emitting layer 17 to align with the upper ends of the pillars 13, it is also possible to form the light emitting layer 17 so as to have inclined surfaces among the pillars 13.

Then, the cathode layer 14 as a second electrode layer is formed by laminating on the light emitting layer 17 (FIG. 3F: second electrode layer forming process). Formation of the cathode layer 14 can be performed by the same manner as the method for forming the anode layer 12.

By the aforementioned processes, the electroluminescent element 10 is manufactured. Further, after the sequence of these processes, a protective layer or a protective cover (not shown) for using the electroluminescent element 10 stably for long periods and protecting the electroluminescent element 10 from outside may be mounted. As the protective layer, polymer compounds, metal oxides, metal fluorides, metal borides, or silicon compounds such as silicon nitrides and silicon oxides may be used. A lamination thereof may also be used. As the protective cover, glass plates, plastic plates with a surface treated with low hydraulic permeability, or metals may be used. The protective cover may be bonded to the support body 11 by using a thermosetting resin or a photo-curable resin to be sealed. At this time, spacers may be used since predetermined spaces may be maintained and the prevention of scratches on the electroluminescent element 10 is facilitated. Filling the spaces with inert gases such as nitrogen, argon and helium prevents the oxidation of the cathode layer 14 on the upper side. Especially, in a case of using helium, high thermal conductivity thereof enables heat generated from the electroluminescent element 10 upon application of voltage to be effectively transmitted to the protective cover. In addition, by putting desiccants such as barium oxide in the spaces, the electroluminescent element 10 is easily prevented from being damaged by moisture absorbed in the sequence of the aforementioned manufacturing processes.

### (Display Device)

Next, description will be given of a display device having the aforementioned electroluminescent element.

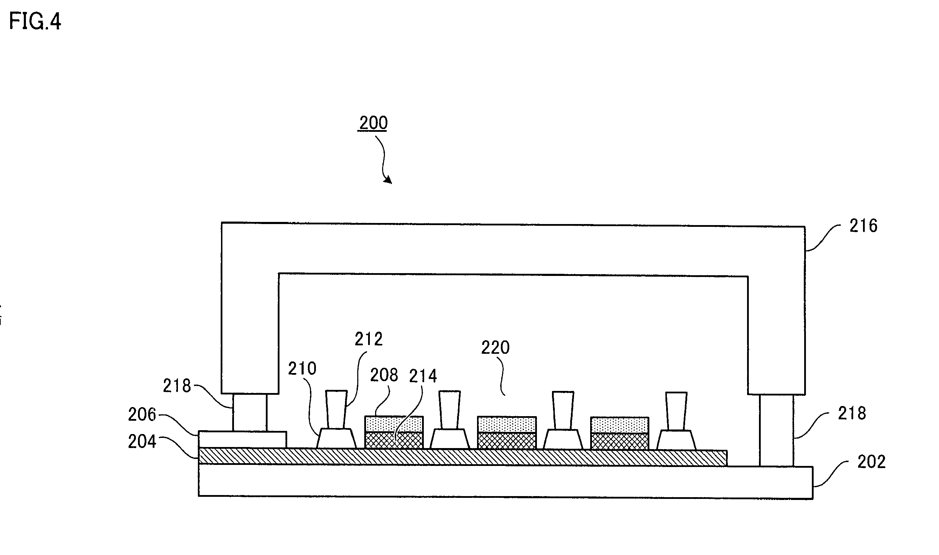

FIG. 4 is a diagram for illustrating a specific example of a display device using the electroluminescent element in the exemplary embodiment.
A display device 200 shown in FIG. 4 is a so-called passive matrix display device, and is provided with a display device support body 202, an anode wiring 204, an auxiliary anode wiring 206, a cathode wiring 208, an insulating film 210, a cathode partition 212, an electroluminescent element 214, a sealing plate 216, and a sealant 218.

The display device support body 202 may employ a transparent support body such as a rectangular glass support body. The thickness of the display device support body 202 is not particularly limited; however, the thickness may be, for example, 0.1 mm to 1 mm.

On the display device support body 202, plural anode wirings 204 are formed. The anode wirings 204 are arranged in parallel with certain intervals. The anode wiring 204 is configured with a transparent conductive film, and can be made of, for example, ITO (indium tin oxide). The thickness of the anode wiring 204 may be set to, for example, 100 nm to 150 nm. The auxiliary anode wiring 206 is formed on an end portion of each of the anode wirings 204. The auxiliary anode wiring 206 is electrically connected to the anode wiring 204. With such a configuration, the auxiliary anode wiring 206 functions as a terminal for connection to an external wiring on the end portion side of the display device support body 202, and accordingly, a current is supplied from a not-shown drive circuit provided outside to the anode wirings 204 through the auxiliary anode wirings 206. The auxiliary anode wiring 206 may be configured with, for example, a metal film having a thickness of 500 nm to 600 nm.

Plural cathode wirings 208 are also provided on the electroluminescent element 214. The plural cathode wirings 208 are arranged in parallel with each other, and each intersecting the anode wirings 204. Aluminum or aluminum alloy may be used for the cathode wiring 208. The thickness of the cathode wiring 208 is, for example, 100 nm to 150 nm. Further, similar to the auxiliary anode wiring 206 for the anode wirings 204, a not-shown auxiliary cathode wiring is provided on an end portion of each of the cathode wirings 208, and is electrically connected to the cathode wiring 208. Consequently, a current is capable of flowing between the cathode wirings 208 and the auxiliary cathode wirings.

On the display device support body 202, the insulating film 210 is formed to cover the anode wirings 204. Opening portions 220 each having a rectangular shape are provided in the insulating film 210 to expose part of the anode wiring 204. The plural opening portions 220 are arranged in a matrix on the anode wirings 204. The electroluminescent elements 214 are provided at the opening portions 220 between the anode wirings 204 and the cathode wirings 208 as will be described later. In other words, each opening portion 220 becomes a pixel. Accordingly, a display region is formed corresponding to the opening portions 220. Here, the thickness of the insulating film 210 can be set to, for example, 200 nm to 300 nm, and the size of the opening portion 220 can be set to, for example, 300 µm square.

The electroluminescent elements 214 are formed at locations corresponding to the positions of the opening portions 220 on the anode wirings 204. Here, in the electroluminescent element 214, the anode layer 12, the pillars 13, the cathode layer 14 and the light emitting layer 17 (refer to FIGS. 1A and 1B) are formed directly on the anode wirings 204 since the anode wirings 204 substitute as the support body 11. The electroluminescent element 214 is held between the anode wirings 204 and the cathode wirings 208 at the opening portion 220. In other words, the anode layer 12 and the cathode layer 14 of the electroluminescent element 214 are in contact with the anode wirings 204 and the cathode wirings 208, respectively. The thickness of the electroluminescent element 214 can be set to, for example, 150 nm to 200 nm.

On the insulating film 210, plural cathode partitions 212 are formed along the direction perpendicular to the anode wirings 204. The cathode partitions 212 play a role in spatially separating the plural cathode wirings 208 so that the cathode wirings 208 are not electrically connected to each other. Accordingly, each of the cathode wirings 208 is arranged between the adjacent cathode partitions 212. The size of the cathode partition 212 may be, for example, 2 µm to 3 µm in height and 10 µm in width.

The display device support body 202 is bonded to the sealing plate 216 with the sealant 218. By this configuration, a space where the electroluminescent elements 214 are provided can be sealed, and thus the electroluminescent elements 214 can be prevented from deteriorating due to moisture in the air. As the sealing plate 216, for example, a glass plate having a thickness of 0.7 mm to 1.1 mm can be used as a support body.

In the display device 200 with such a configuration, a current is supplied to the electroluminescent elements 214 via the auxiliary anode wirings 206 and the not-shown auxiliary cathode wirings from a not-shown driving device to cause the light emitting layer 17 to emit light so that the light is outputted from the spaces among the pillars 13 (refer to FIGS. 1A and 1B). By controlling light emission and non-light emission of the electroluminescent elements 214 corresponding to the aforementioned pixels, images can be displayed on the display device 200.
In such a display device 200, each pixel is independent and blinks to indicate an image or pictogram; however, in the case where the electroluminescent element according to the exemplary embodiment is not used, each pixel is easily disabled to light due to the short circuit or the like, and thereby functions as the display device are impaired. For this reason, the electroluminescent element according to the exemplary embodiment capable of suppressing the short circuit or the like is useful.

### (Illumination Device)

Next, description will be given of an illumination device using the electroluminescent elements 10.

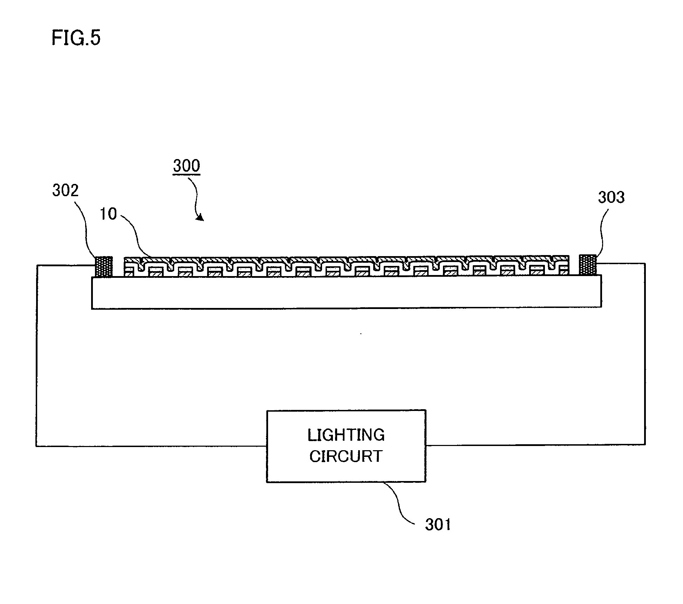

FIG. 5 is a diagram for illustrating a specific example of an illumination device having the electroluminescent element in the exemplary embodiment.
An illumination device 300 shown in FIG. 5 is configured with: the aforementioned electroluminescent element 10; a terminal 302 that is provided adjacent to the support body 11 (refer to FIGS. 1A and 1B) of the electroluminescent element 10 and is connected to the anode layer 12 (refer to FIGS. 1A and 1B); a terminal 303 that is provided adjacent to the support body 11 (refer to FIGS. 1A and 1B) and is connected to the cathode layer 14 (refer to FIGS. 1A and 1B) of the electroluminescent element 10; and a lighting circuit 301 that is connected to the terminals 302 and 303 to drive the electroluminescent element 10.

The lighting circuit 301 has a not-shown DC power supply and a not-shown control circuit inside thereof, and supplies a current between the anode layer 12 and the cathode layer 14 of the electroluminescent element 10 via the terminals 302 and 303. The lighting circuit 301 drives the electroluminescent element 10 to cause the light emitting layer 17 (refer to FIGS. 1A and 1B) to emit light, the light is outputted through the support body 11, and the light is utilized for illumination. The light emitting layer 17 may be configured with the light emitting material that emits white light, or, it may be possible to provide plural electroluminescent elements 10 using a light emitting material that outputs each of the green light (G), blue light (B) and red light (R), thus making a synthetic light white. It should be noted that, in the case where light emission is performed with spaces among the pillars 13 (refer to FIGS. 1A and 1B) being reduced, the illumination device 300 of the exemplary embodiment seems to perform surface emitting to the human eye.
Such an illumination device 300 provides light by lighting a single element with large area; however, in the case where the electroluminescent element according to the exemplary embodiment is not used, the entire illumination device 300 becomes disabled to light due to one portion in the light emitting surface that is disabled to light by short circuit or the like, and thereby functions of the illumination device 300 are impaired. Consequently, the electroluminescent element according to the exemplary embodiment capable of suppressing the short circuit or the like is useful.

### [Examples]

### [Evaluation]

### (Evaluation of Short Circuit or the Like)

Evaluation of the short circuit or the like was conducted by a method in which a voltage is applied to the electroluminescent element with a reverse bias (that is, a positive voltage is applied to the cathode layer 14 side and a negative voltage is applied to the anode layer 12 side), and a current value at that time was measured. In other words, in the state of the reverse bias, normally, no current passes through the electroluminescent element; however, if there is short circuit or the like, current passes. The larger the current value is, the more the short circuit or the like occurs. In the exemplary embodiment, a voltage of 15V was applied with a reverse bias to an electroluminescent element having a light emitting area of 10 mm square, and a current value of the case (a short circuit current) was measured.

### (Evaluation of Durability)

A current is passed through the electroluminescent element to emit light, and brightness is measured with time. Then, the shorter one of the time when brightness was reduced to half in brightness at an early stage of lighting and the time when the electroluminescent element became disabled to light was assumed as a life of the electroluminescent element, to thereby evaluate durability. In the exemplary embodiment, evaluation was conducted by passing a current of 10 mA through an electroluminescent element having a light emitting area of 10 mm square.

### (Calculation of Pillar Shape Normality)

A test sample including the support body 11, the anode layer 12 and the pillars 13 was obtained by soaking an electroluminescent element in chloroform and leaving it for 24 hours (that is, the light emitting layer 17 and the cathode layer 14 were removed). From the surface of the test sample, by use of AFM (VN8010 manufactured by KEYENCE CORPORATION), a computer image of a portion surrounded by a square of 100 µm on a side was obtained. For the image, arbitrary x and y coordinates were extracted by using a table of random numbers, a circle with a diameter (S), which is a proper distance between the pillars 13 (the distance between the pillars 13 of the electroluminescent element according to the specification) was rendered, and whether there was any pillar 13 in the circle or not was confirmed (if exists, counted as 1, and if does not, counted as 0). Moreover, a circle around the same points with a diameter of 2S µm was rendered to confirm whether the light emitting layer 17 was present or absent. A number of counts A as a result of measurement at 300 points (according to the specification, A is 600) was calculated, and A/600 was assumed to be the pillar shape normality.

### (Example A-1)

### [Preparation of Phosphorescent Light emitting Polymer Compound]

The compounds expressed by the chemical formulas E-2 (iridium complex having a polymerizing substituent), E-54 (hole transporting compound) and E-66 (electron transporting compound) were dissolved in dehydrated toluene with the ratio (mass ratio) of E-2:E-54:E-66 = 1:4:5, and V-601 (manufactured by Wako Pure Chemical Industries, Ltd.) as a polymeric initiator was further dissolved therein. After freeze pumping operation, vacuum seal was performed, and the resultant solution was stirred for 100 hours at 70 degrees C for polymerization reaction. After the reaction, the reaction solution was delivered by drops into acetone to cause deposition, and then reprecipitation purification with dehydrated toluene-acetone was repeated three times to purify the phosphorescent light emitting polymer compound. Here, as each of dehydrated toluene and acetone, solution distilled from high-purity solution manufactured by Wako Pure Chemical Industries, Ltd. was used.
By analyzing the solution after the third reprecipitation purification by high-performance liquid chromatography, it was confirmed that any material absorbing light at regions not less than 400 nm was not detected in the solution. In other words, it means that impurities were hardly contained in the solution, and the phosphorescent light emitting polymer compound was sufficiently purified. Then, the purified phosphorescent light emitting polymer compound was vacuum-dried for two days at room temperature. The phosphorescent light emitting polymer (ELP) obtained by this operation was confirmed to have the purity of over 99.9% by the high-performance liquid chromatography (detection wavelength: 254 nm).

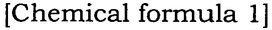

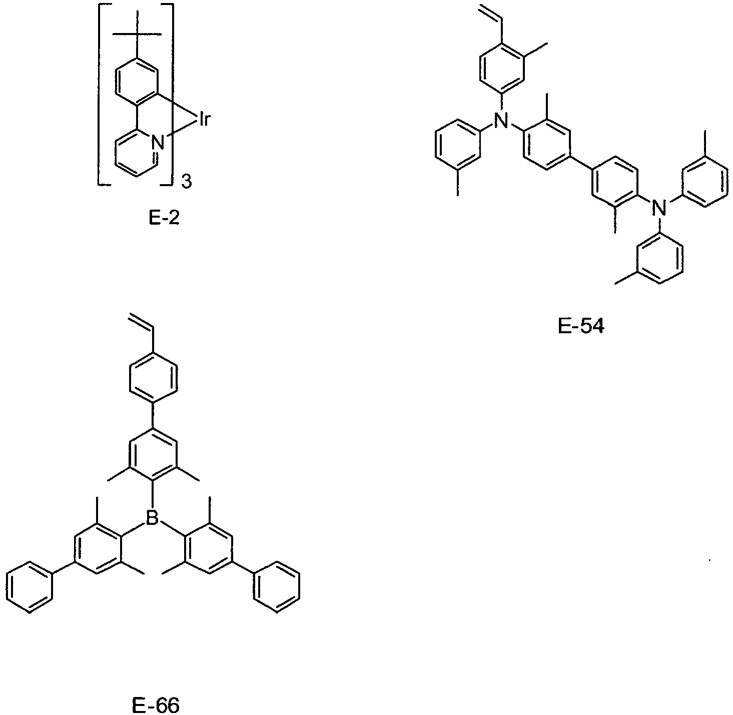

### [Preparation of Light Emitting Material Solution]

A light emitting material solution (hereinafter, also referred to as "solution A") was prepared by dissolving 3 parts by weight of the light emitting polymer compound prepared as mentioned above (weight-average molecular weight = 52000) in 97 parts by weight of toluene.

### [Preparation of electroluminescent Element]

As an electroluminescent element, the electroluminescent element 10 shown in FIGS. 1A, 1B and FIG. 2A was prepared by the method described with FIGS. 3A to 3F.
Specifically, first, as the support body 11, a soda glass plate (Rmax = 3 nm (reference length L is 50 µm), 25 mm square) with a thickness of 0.7 mm, the surface of which had been polished, was used. On this soda glass plate, an ITO (indium tin oxide) film of 50 nm in thickness as the anode layer 12 was formed by a sputtering device (E-401s manufactured by Canon ANELVA Corporation). When Rmax of the surface of the ITO film was measured, Rmax was 50 nm. Further on the ITO film, a silicon dioxide (SiO₂) layer of 100 nm in thickness was formed by the sputtering device (E-401s manufactured by Canon ANELVA Corporation).

Next, a photoresist (AZ1500 manufactured by AZ Electronic Materials) of about 1 µm in thickness is formed by a spin coating method. After ultraviolet light exposure, development is executed with 1.2% aqueous solution of TMAH (tetramethyl ammonium hydroxide: (CH₃)₄NOH), to thereby pattern the resist layer 71.

Subsequently, dry etching using a reactive ion etching device (RIE-200iP manufactured by SAMCO Inc.) is performed to pattern the silicon dioxide layer as shown in FIG. 2A. On this occasion, the etching conditions are: using CHF₃ as a reactant gas; and causing a reaction for 16 minutes under a pressure of 0.3 Pa and output bias/ICP = 60/100 (W).
With the above-described dry etching process, space portions formed among the pillars 13 were formed. By forming the space portions, the pillars 13 had cylindrical shape with a radius of 0.5 µm and a depth of 100 nm. Moreover, a distance between the respective pillars 13 (pillar-to-pillar distance) was 0.5 µm (in other words, center positions of the pillars 13 were 1 µm away from each other).

Next, cleaning was performed by squirting pure water, and then dried by a spin dryer.
Next, solution A was applied by the spin coating method (spin rate: 3000 rpm), and leaving under a nitrogen atmosphere at the temperature of 120°C for an hour to be dried, to thereby form the light emitting layer 17.

Then, upon being placed in a vacuum deposition chamber, a sodium (Na) film having the thickness of 2.0 nm as the cathode buffer layer was formed on the light emitting layer 17 by a vacuum deposition equipment. Subsequently, an aluminum (Al) film having the thickness of 150 nm as the cathode layer 14 was formed. The electroluminescent element 10 was able to be prepared by the aforementioned processes.

### (Examples A-2 to A-6, Comparative Example A-1)

The electroluminescent elements 10 were prepared in the same manner as Example A-1 except that the pillar-to-pillar distance was changed as shown in Table 1.

### (Comparative Example A-2)

The electroluminescent element 10 shown in FIGS. 7A and 7B was prepared. Here, the electroluminescent element 10 can be produced by laminating the anode layer 12, the light emitting layer 17 and the cathode layer 14 in order on the support body 11. On this occasion, materials or thickness of the light emitting layer 17 or the cathode layer 14 was the same as those in Example A-1.

### (Examples A-7 to A-8, Comparative Examples A-3 to A-4)

The electroluminescent elements 10 were prepared in the same manner as Example A-1 except that the height of the pillar 13 was changed as shown in Table 1.

Evaluations of the above items are collectively shown in Table 1.

**[Table 1]**

| | Pillar-to-Pillar Distance | Pillar Height | Short Circuit Current | Life | Remarks |
|---|---|---|---|---|---|
| | (µm) | (nm) | (mA) | (h) | |
| Example A-1 | 0.5 | 100 | 0.001 | 2000 | |
| Example A-2 | 1 | 100 | 0.002 | 2000 | |
| Example A-3 | 1.5 | 100 | 0.01 | 1700 | |
| Example A-4 | 3 | 100 | 0.02 | 1600 | |
| Example A-5 | 5 | 100 | 0.1 | 1400 | |
| Example A-6 | 10 | 100 | 0.15 | 1000 | |
| Example A-7 | 1 | 50 | 0.01 | 1600 | |
| Example A-8 | 1 | 300 | 0.001 | 1200 | |
| Comparative Example A-1 | 20 | 100 | 2 | 250 | disabled to light halfway |
| Comparative Example A-2 | - | - | 4 | 10 | disabled to light halfway |
| Comparative Example A-3 | 1 | 25 | 0.5 | 350 | disabled to light halfway |
| Comparative Example A-4 | 1 | 500 | 0 | 350 | disabled to light halfway |

When Examples A-1 to A-8 and Comparative Example A-1 are compared, in any of evaluation of short circuit or the like and evaluation of durability, the smaller the distance between the pillars 13, the better the results are. Moreover, in the case of comparative Example A-1 where the distance between the pillars 13 was set to 20 µm, which exceeded 10 µm, and in the case of Comparative Example A-2 where the pillars 13 were not provided, the electroluminescent element 10 was disabled to light halfway in the evaluation of durability. From this, it can be learned that the distance between the pillars 13 is required to be 10 µm or less. In other words, it is necessary to form the pillars 13 such that at least a part of the pillar 13 is included in an arbitrary circular region with a diameter of 10 µm between the anode layer 12 and the cathode layer 14.

When Examples A-2, A-7, A-8, Comparative Examples A-3 and A-4 are compared, effect for suppressing the short circuit or the like was deteriorated in the case where the height of the pillars 13 was less than 50 nm. In the case where the height of the pillars 13 was more than 300 nm, the short circuit or the like was preferably suppressed; however, durability raising effect was small. This can be considered that, when the pillars 13 were excessively low, effect for suppressing the short circuit or the like was deteriorated, whereas, when the pillars 13 were excessively high, though it is efficient to suppress the short circuit or the like, the space between the anode layer 12 and the cathode layer 14 was too large to function as an electroluminescent element, and therefore durability was deteriorated.

### (Examples B-1 to B-10)

Electroluminescent elements 10 were prepared in which area occupancy rate of the pillars 13 was changed by setting the diameter of the pillar 13 to 1 µm and changing the distance between the pillars 13 as shown in Table 2. The area occupancy rate of the pillars 13 was calculated from the pattern of the photomask used for processing the pillars 13. It should be noted that other values were set similar to those in Example A-1.

Evaluations of the above items are collectively shown in Table 2.

**[Table 2]**

| | Pillar-to-Pillar Distance | Area Occupancy Rate of Pillars | Short Circuit Current | Life |
|---|---|---|---|---|
| | (µm) | (%) | (mA) | (h) |
| Example B-1 | 0.02 | 87.1 | 0.001 | 100 |
| Example B-2 | 0.06 | 80.7 | 0.001 | 1000 |
| Example B-3 | 0.15 | 68.5 | 0.001 | 1400 |
| Example B-4 | 0.25 | 58.0 | 0.001 | 1800 |
| Example B-5 | 0.5 | 40.3 | 0.002 | 2000 |
| Example B-6 | 1 | 22.7 | 0.002 | 2000 |
| Example B-7 | 2 | 10.1 | 0.003 | 1800 |
| Example B-8 | 3 | 5.7 | 0.004 | 1600 |
| Example B-9 | 5 | 2.5 | 0.02 | 1200 |
| Example B-10 | 10 | 0.7 | 0.1 | 500 |

As can be learned from Table 2, in the case where the area occupancy rate of the pillars was in the range of 10% to 60%, both evaluation of the short circuit or the like and evaluation of durability were exceptionally good. Moreover, in the case where the area occupancy rate of the pillars was in the range of 5% to 10% and in the range of 60% to 70%, evaluations were considerably good. Further, in the case where the area occupancy rate of the pillars was in the range of 3% to 5% and in the range of 70% to 80%, evaluations were good.
On the other hand, when the area occupancy rate of the pillars is less than 5% and more than 80%, both evaluation of the short circuit or the like and evaluation of durability tend to be low.

### (Examples C-1 to C-3)

By the method of Example A-2, 30 electroluminescent elements 10 were prepared, and pillar shape normality was measured in each electroluminescent element 10, to thereby extract one having the highest value, average one and one having the lowest value therefrom. They were 100% (Example C-1), 97% (Example C-2) and 95% (Example C-3), respectively.

Evaluations of the above items are collectively shown in Table 3.

**[Table 3]**

| | Pillar Shape Normality | Short Circuit Current | Life |
|---|---|---|---|
| | (%) | (mA) | (h) |
| Example C-1 | 100 | 0.002 | 2100 |
| Example C-2 | 97 | 0.003 | 2000 |
| Example C-3 | 95 | 0.004 | 1900 |

As can be learned from Table 3, even if there are defects in the pillars 13, fluctuations provided to the short circuit or the like and durability is a little.

### (Relation between Rmax and Short Circuit or the Like)

Anode layers 12 having the surface roughness (Rmax) (reference length L is 50 µm) as shown in Table 4 were provided, and electroluminescent elements 10 were prepared by the method of Example A-1 and electroluminescent elements 50 were prepared by the method of Comparative Example A-2. Then, evaluation of the short circuit or the like was conducted by the above-described method.
Here, with respect to Example A-1, the thickness of the ITO (indium tin oxide) film was changed into the range of 30 nm to 150 nm. In addition to this, by adjusting pressure and flow rate of argon (Ar), which is a sputtering gas, sputtering voltage, distance between the ITO target and the support body 11 and temperature, the ITO films having various surface roughness (Rmax) can be prepared.

The results are shown in Table 4.

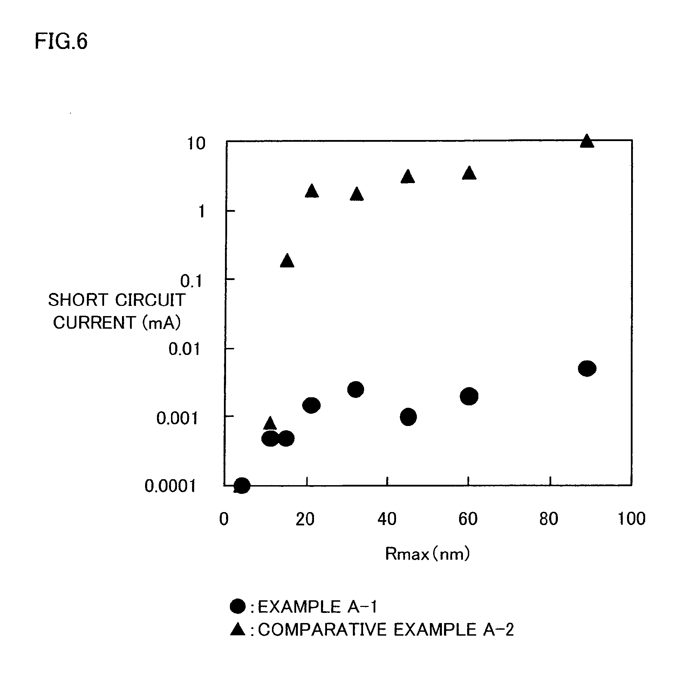

FIG. 6 is a diagram showing a relation between the surface roughness (Rmax) and the short circuit or the like.
As shown in FIG. 6, in the electroluminescent elements 50 of the Comparative Example A-2, as the surface roughness (Rmax) becomes larger, the short circuit or the like is remarkably increased. On the other hand, in the electroluminescent elements 10 of Example A-1, the short circuit or the like is not increased so much. From this, it can be learned that it is possible to effectively suppress the short circuit or the like by employing the structure of the electroluminescent element 10 in the exemplary embodiment.
However, in the case where the surface roughness (Rmax) of the anode layer 12 is less than 10 nm, the short circuit or the like is small even in the electroluminescent element 50 of Comparative Example A-2; and therefore, the effect of suppressing the short circuit or the like by the electroluminescent element 10 of Example A-1 is comparatively small. From this, it can be learned that the structure of the electroluminescent element 10 in the exemplary embodiment is more effective in the case where the surface roughness (Rmax) of the anode layer 12 is 10 nm or more and the short circuit or the like is to be suppressed.

**[Table 4]**

| Rmax | Short Circuit Current (mA) | |
|---|---|---|
| | Method of Example A-1 | Method of Comparative Example A-2 |
| 4 | 0.0001 | 0.0002 |
| 11 | 0.0005 | 0.0008 |
| 15 | 0.0005 | 0.19 |
| 21 | 0.0015 | 1.9 |
| 32 | 0.0025 | 1.8 |
| 45 | 0.001 | 3.2 |
| 60 | 0.004 | 3.5 |
| 89 | 0.007 | 10 |
| 100 | 0.01 | 12 |
| 200 | 1 | 20 |
| 250 | 15 | 20 |

### Reference Signs List

10: Electroluminescent element
11: Support body
12: Anode layer
13: Pillars
14: Cathode layer
17: Light emitting layer
200: Display device
300: Illumination device

## Claims

1. An electroluminescent element comprising:
a first electrode layer;
a second electrode layer arranged to face the first electrode layer;
pillars formed in a space between the first electrode layer and the second electrode layer; and
a light emitting layer formed in a location other than locations where the pillars are formed,
wherein the pillars are formed to satisfy (1) and (2) below at a rate of 95% or more:
(1) at least a part of the pillars is included in a circular region with a diameter of 10 µm around an arbitrary position on a surface of the first electrode layer; and
(2) at least a part of the light emitting layer is included in a circular region with a diameter of 20 µm around an arbitrary position on a surface of the first electrode layer.

2. The electroluminescent element according to claim 1, wherein a surface roughness (Rmax) of a surface of the first electrode layer, on which the pillars are to be formed, is 10 nm or more assuming that a reference length L is 50 µm.

3. The electroluminescent element according to any one of claims 1 and 2, wherein height of the pillar is 50 nm to 300 nm.

4. The electroluminescent element according to any one of claims 1 to 3, wherein the pillar substantially has a cylindrical shape.

5. The electroluminescent element according to any one of claims 1 to 4, wherein the light emitting layer includes an organic material that emits phosphorescent light.

6. An electroluminescent element manufacturing method comprising:
forming a first electrode layer on a support body;
forming pillars on the first electrode layer;
forming a light emitting layer by a coating method in a location other than locations where the pillars are formed; and
forming a second electrode layer on the pillars and the light emitting layer,
wherein the pillars are formed to satisfy (1) and (2) below at a rate of 95% or more:
(1) at least a part of the pillars is included in a circular region with a diameter of 10 µm around an arbitrary position on a surface of the first electrode layer; and
(2) at least a part of the light emitting layer is included in a circular region with a diameter of 20 µm around an arbitrary position on a surface of the first electrode layer.

7. The electroluminescent element manufacturing method according to claim 6, wherein the coating method is any one of a spin coating method, an ink-jet method, a printing method and a slit coating method.

8. A display device comprising the electroluminescent element according to any one of claims 1 to 5.

9. An illumination device comprising the electroluminescent element according to any one of claims 1 to 5.
